# EUROPEAN PATENT SPECIFICATION

(11) **EP 2 280 236 B1**
(45) Date of publication and mention of the grant of the patent: **01.05.2013**
(21) Application number: 09009941.7
(22) Date of filing: 31.07.2009
(51) Int. Cl.: F28D 15/02, H01L 23/427

(54) **Heat-dissipating fins, large-area heat sink having such heat-dissipating fins and method for manufacturing the same**
Wärmeableitende Rippen, Kühlkörper für einen großen Bereich mit den wärmeableitenden Rippen und Herstellungsverfahren dafür
Ailettes à dissipation de chaleur, dissipateur de chaleur pour grande surface doté de ces ailettes à dissipation de chaleur et leur procédé de fabrication

(43) Date of publication of application: 02.02.2011
(73) Proprietor: CPUMATE INC., Taipei County 248 (TW); Golden Sun News Techniques Co., Ltd., Taipei County 248 (TW)
(72) Inventor: Lin, Kuo-Len, Taipei County 248 (TW); Lin, Chen-Hsiang, Taipei County 248 (TW); Hsu, Ken, Taipei County 248 (TW); Cheng, Chih-Hung, Taipei County 248 (TW)
(74) Representative: TER MEER - STEINMEISTER & PARTNER GbR

(56) References cited:
- EP-A- 1 921 410
- US-A1- 2007 261 244
- US-A1- 2008 257 527

## Description

### BACKGROUND OF THE INVENTION

### 1. Field of the Invention

The present invention relates to a heat-dissipating fin, a heat sink with such fin, and a method for manufacturing a heat sink. A fin according to the preamble of claim 10 is known from US 2008/0257527A1. This document also discloses a method according to the preamble of claim 1.

### 2. Description of Prior Art

Electronic elements will generate heat during their operations. Especially, with the advancement of the science and technology, the functions and performance of an electronic product are enhanced substantially. As a result, the heat generated by the electronic product also increases to a much larger extent. In view of this, most of the electronic elements are provided with a heat sink to control its working temperature and maintain its normal operation. It is a well-known heat sink including a stack of heat-dissipating fins and heat pipes penetrating the stack of heat-dissipating fins.

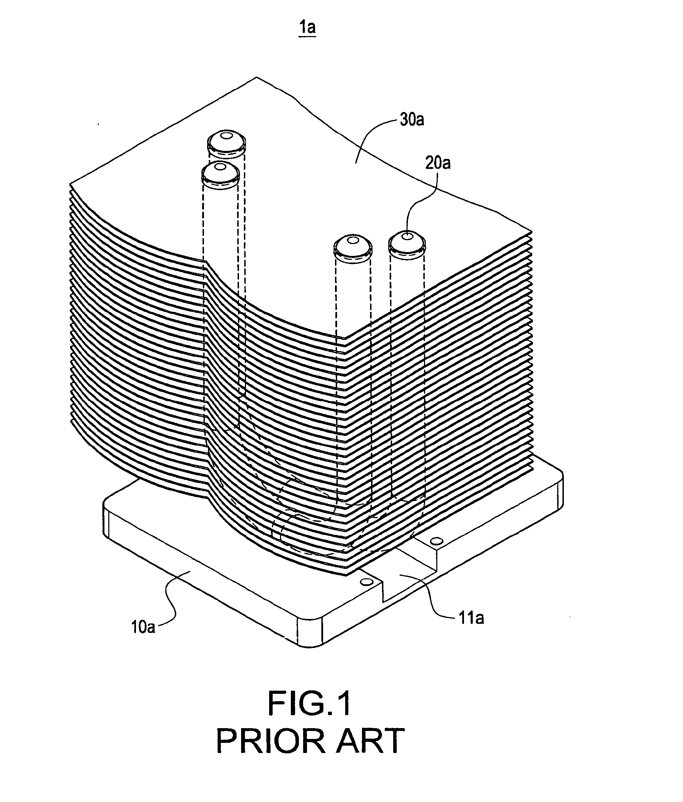

Please refer to FIG. 1, which is a schematic view showing the conventional combination of heat pipes and heat-dissipating fins. The heat sink 1a comprises a heat-conducting base 10a, two U-shaped heat pipes 20a and a plurality of fins 30a. The heat-conducting base 10a is provided with a plurality of grooves 11a. The two U-shaped heat pipes 20a are inserted into the grooves 11a. The heat pipe 20a penetrates through-holes of the plurality of fins 30a. With this arrangement, the heat-conducting base 10a is adhered to a heat-generating element. The heat sink 1a can conduct the heat generated by the heat-generating electronic element quickly.

In the above structure, the heat is conducted from the heat pipe 20a to the fins 30a. Then, the fins 30a dissipate the heat quickly to the outside. However, the heat pipes 20a cannot conduct the heat uniformly throughout the fins 30a, so that the portions away from the heat pipe 10a are poor in heat-dissipating efficiency. Moreover, with the continuous improvement in the performance of electronic elements, the heat generated by the electronic elements is increased accordingly. Thus, the heat-dissipating efficiency of the heat sink also has to be improved. Due to the limited volume of the current electronic product, it is an important issue to increase the heat-dissipating area of the heat sink 1a as large as possible in order to increase the heat-dissipating efficiency.

Therefore, in order to solve the above-mentioned problems, the present Inventor proposes a reasonable and novel structure based on his deliberate research and expert experiences.

### SUMMARY OF THE INVENTION

The present invention is to provide a fin according to claim 10 and a heat sink of a large area according to claim 12. A heat-dissipating body is further provided in a limited space, so that the fins and the heat-dissipating body can dissipate the heat of a heat-generating element. In this way, the heat-dissipating efficiency can be enhanced.

The present invention is to provide a method for manufacturing a heat sink of a large area according to claim 1.

In comparison with prior art, since the fin of the present invention is provided with a folded piece and an accommodating hole, in case of a limited space, the present invention does not need additional space for arranging the fins. Not only the heat sink has a plurality of fins, but also a heat-dissipating body can be further disposed in the accommodating holes of the fins. The heat sink of the present invention has a larger heat-dissipating area than that in prior art. Since the fins and the heat-dissipating body dissipate the heat of the heat-generating element simultaneously, the heat-dissipating efficiency of the heat sink can be increased. Thus, the practicability of the present invention can be increased.

### BRIEF DESCRIPTION OF THE DRAWINGS

FIG. 1 is a schematic view showing the conventional combination of heat pipes and heat-dissipating fins;
FIG. 2 is a flow chart showing the method for manufacturing the heat sink of a large area according to the present invention;
FIG. 3 is an assembled view showing the heat sink of a large area according to the present invention;
FIG. 4A is a view showing the action for cutting the fin of the present invention;
FIG. 4B is a view showing the action for folding back the foldable piece of the fin according to the present invention;
FIG. 4C is a view showing the action for punching the fin and the folded piece according to the present invention;
FIG. 4D is a view showing the action for pressing the fin and the folded piece according to the present invention;
FIG. 5 is a perspective view showing the external appearance of the heat sink of the present invention;
FIG. 6 is a longitudinal cross-sectional view showing the heat sink of the present invention;
FIG. 7 is a transverse cross-sectional view showing the heat sink of the present invention;
FIG. 8 is a schematic view showing the operating state of the heat sink of the present invention; and
FIG. 9 is a view showing the heat sink according to the second embodiment of the present invention.

### DETAILED DESCRIPTION OF THE INVENTION

The characteristics and technical contents of the present invention will be described with reference to the accompanying drawings. However, the drawings are illustrative only but not used to limit the present invention.

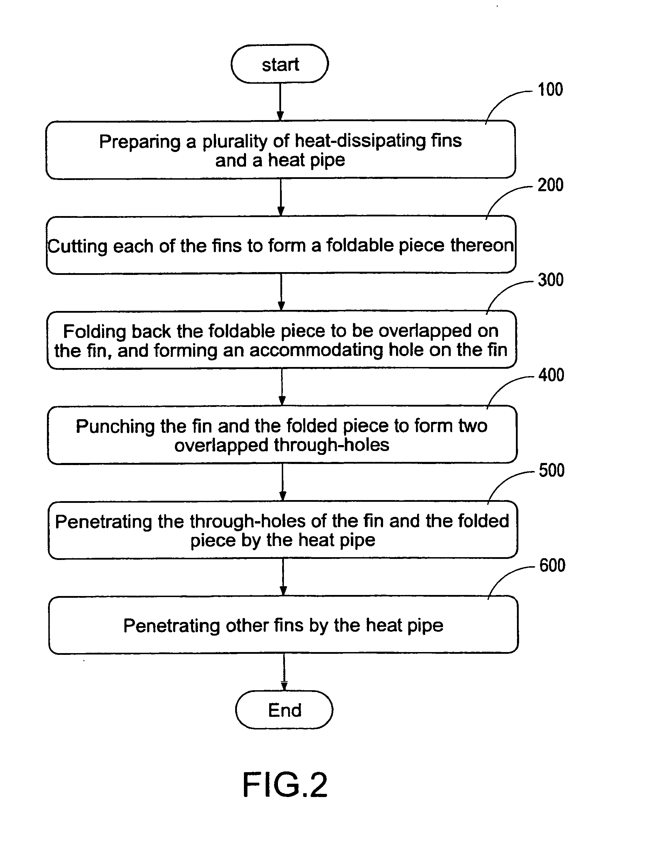

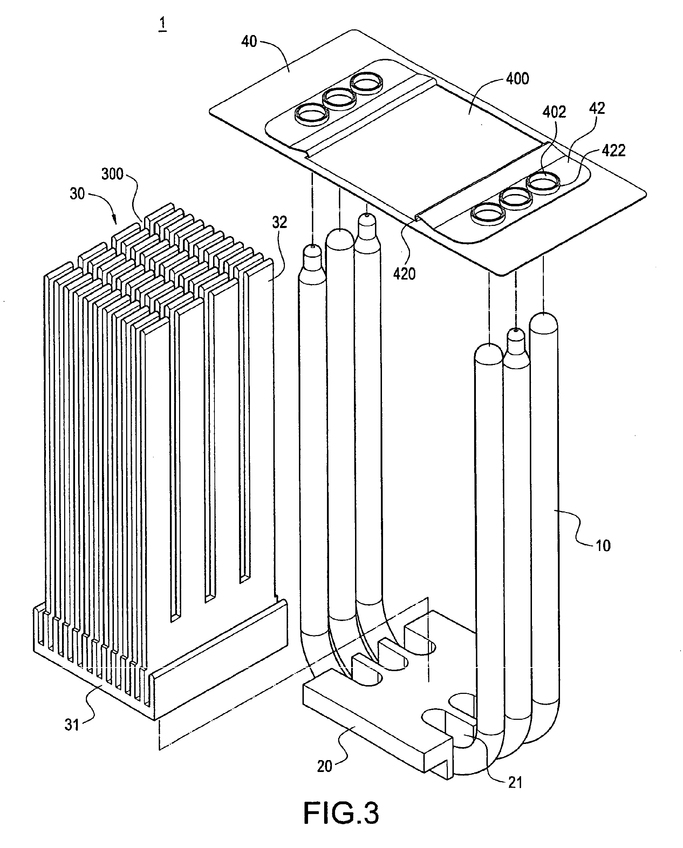

Please refer to FIGS. 2 and 3. FIG. 2 is a flow chart showing the method for manufacturing the heat sink of a large area according to the present invention, and FIG. 3 is an assembled view showing the heat sink of a large area according to the present invention. First, a heat pipe 10, a heat-conducting base 20, a heat-dissipating body 30 and a plurality of fins 40 are provided (step 100). The heat pipe 10 penetrates the heat-conducting base 20.

In the present embodiment, there are three heat pipes 10 each formed into a U shape, but the number of the heat pipes 10 is not limited thereto. The bottom surface of the heat-conducting base 20 is provided with three grooves 21 to correspond to the number of the heat pipes 10. The three heat pipes 10 are inserted into the grooves 21. The heat-dissipating body 30 is an aluminum-extruded fin which has a base 31 and a plurality of extending pieces 32 extending upwards from the base 31. The extending pieces 32 are parallel to each other and arranged at intervals. A channel 300 is formed between any two extending pieces 32. Further, the fins 40 are penetrated by the heat pipe 10.

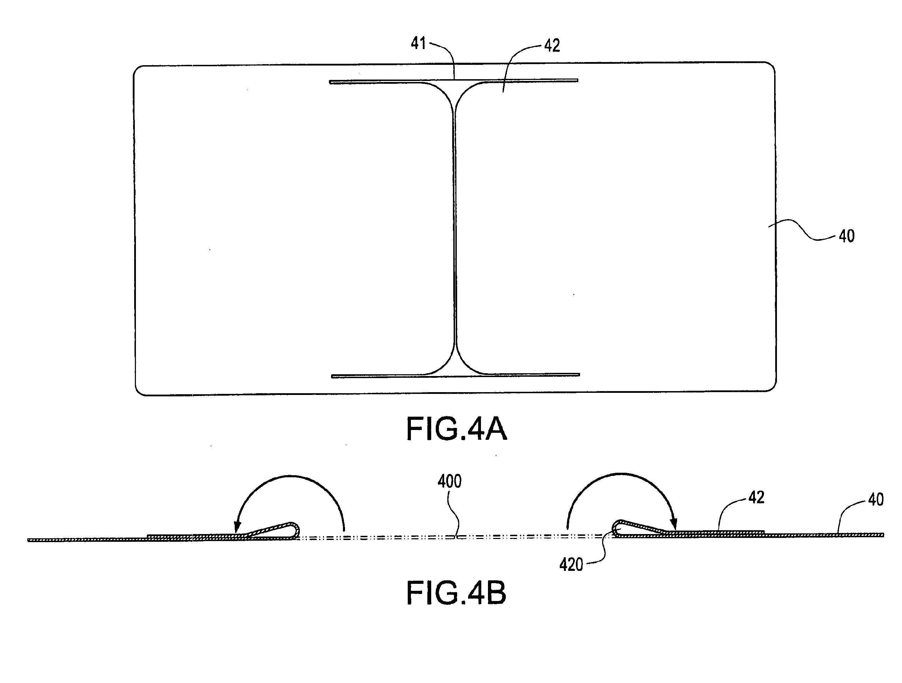

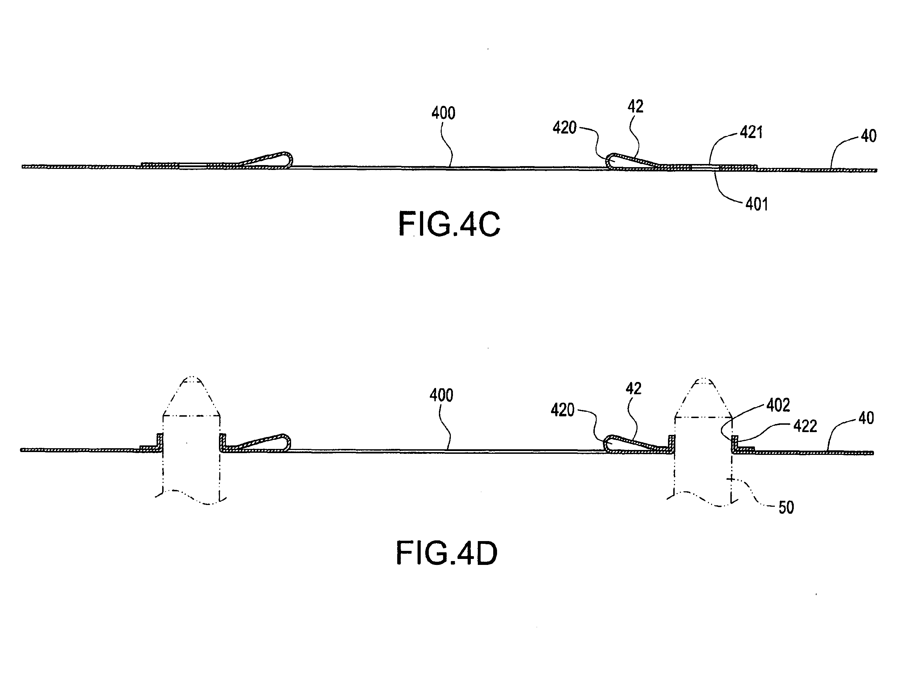

Please refer to FIGS. 4A to 4D, which show the method for manufacturing the fin 40. First, a tool (not shown) is used to cut the fin 40 (step 200) so as to form a plurality of cutting lines 41 on the fin 40. The cutting lines 41 form at least one foldable piece 42 on the fin 40. For example, if the cutting lines 41 forms a U shape, one foldable piece 42 can be formed on the fin 41. If the cutting lines 41 formed an H shape, both sides of the fin 40 can generate a foldable piece 42 respectively.

Please refer to FIG. 4B. Then, the foldable piece 42 is folded back, so that the folded piece 42 can be overlapped on the fin 40. A hollow airflow channel 420 is formed between the folded piece 42 and the fin 40. The hollow airflow channel 420 allows airflow to flow through to take away the heat. As a result, the fin 40 is formed with an accommodating hole 400 (step 300). Then, the fin 40 and the folded piece 42 are punched to form two overlapped through-holes 401, 402 (step 400). In the present embodiment, the step 400 is performed after the step 300. That is, in the present embodiment, the fin 40 and the folded piece 42 overlapped on the fin 40 are punched at the same time. Alternatively, the step 400 can be performed before the step 300. That is, in the step 400, the fin 40 and the foldable piece 42 are first punched to form two overlapped through-holes 401, 402. Then, the step 300 is performed. The foldable piece 42 is folded back to be overlapped on the fin 40, so that the two through-holes 401, 402 are overlapped. Then, a tool 50 is used to press the peripheries of the two through-holes 401, 421. In this way, the peripheries of the two through-holes 401, 421 are formed with two overlapped flanges 402, 422.

The two through-holes 401, 422 of the fin 40 and the folded piece 42 are aligned with the heat pipe 10, so that the fin 40 and the folded piece 42 can be penetrated by the heat pipe 10 (step 500). The base 31 of the heat-dissipating body 30 is disposed on the top surface of the heat-conducting base 20 and is accommodated in the accommodating hole 400 of the fin 40.

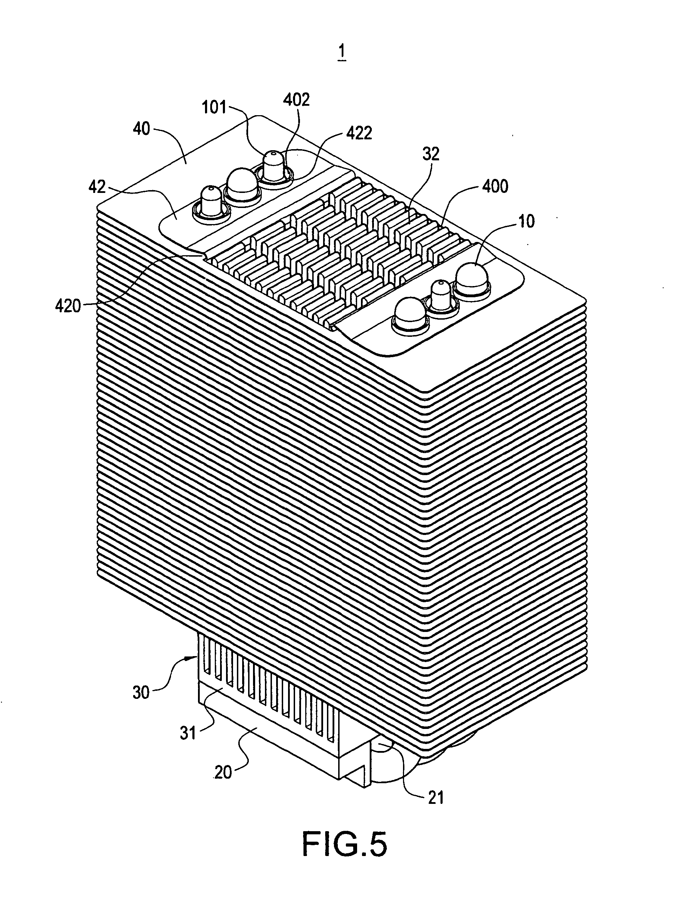

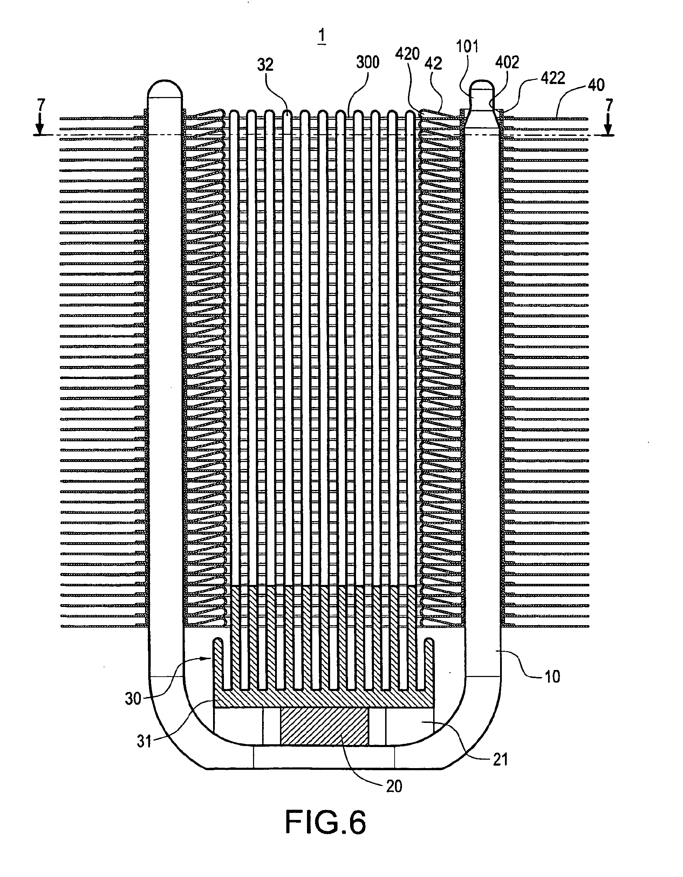

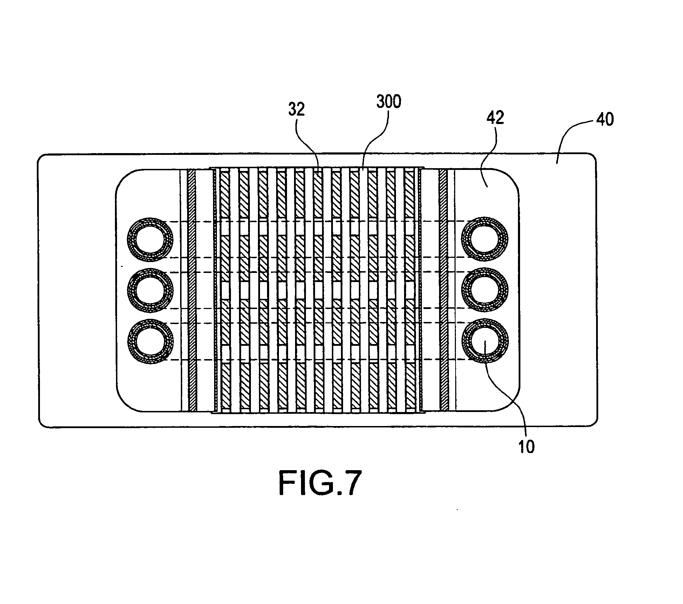

Please refer to FIGS. 5 to 7. Fig. 5 is a perspective view showing the external appearance of the heat sink of the present invention. FIG. 6 and FIG. 7 are cross-sectional views of the present invention respectively. Following the above steps, other fins can be penetrated by the heat pipe 10 (step 600), thereby completing a heat sink 1. It can be seen that the flange 402 of the through-hole 401 of the fin 40 is adhered to an outer wall of the heat pipe 10 tightly (excluding a narrowed section 101 of the heat pipe 10). Most of the extending pieces 32 of the heat-dissipating body 30 are accommodated in the accommodating holes 400 of a stack of fins 40. In addition, the channels 300 of the heat-dissipating body 20 are in communication with each other.

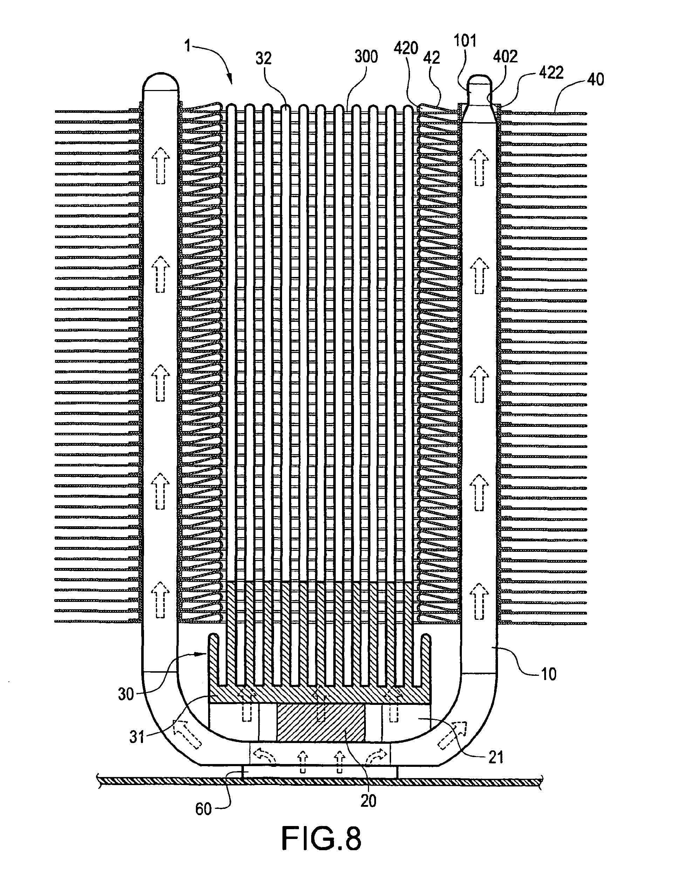

Please refer to FIG. 8, which is a schematic view showing the operating state of the heat sink of a large area according to the present invention. When the heat sink 1 is used to dissipate the heat of a heat-generating electronic element 60, the heat-conducting base 20 and the bottom section of the heat pipe 10 are adhered to the surface of the heat-generating electronic element 60. The heat generated by the heat-generating electronic element 60 is conducted to the heat-conducting base 20 and the heat pipe 10. The heat is further conducted to the fins 40 by means of the heat pipe 10. On the other hand, the heat conducted to the heat-conducting base 20 is further conducted to the heat-dissipating body 30. As a result, the extending pieces 32 dissipate the heat into the channels 300 that are in communication with each other. The fins 40 and the heat-dissipating body 30 are used to dissipate the heat of the heat-generating electronic element 60 at the same time to the outside. In this way, the temperature of the heat-generating electronic element 60 can be reduced, and the accumulation of heat on the heat-generating electronic element 60 can be prevented. Thus, the heat-dissipating efficiency of the heat sink 1 is increased.

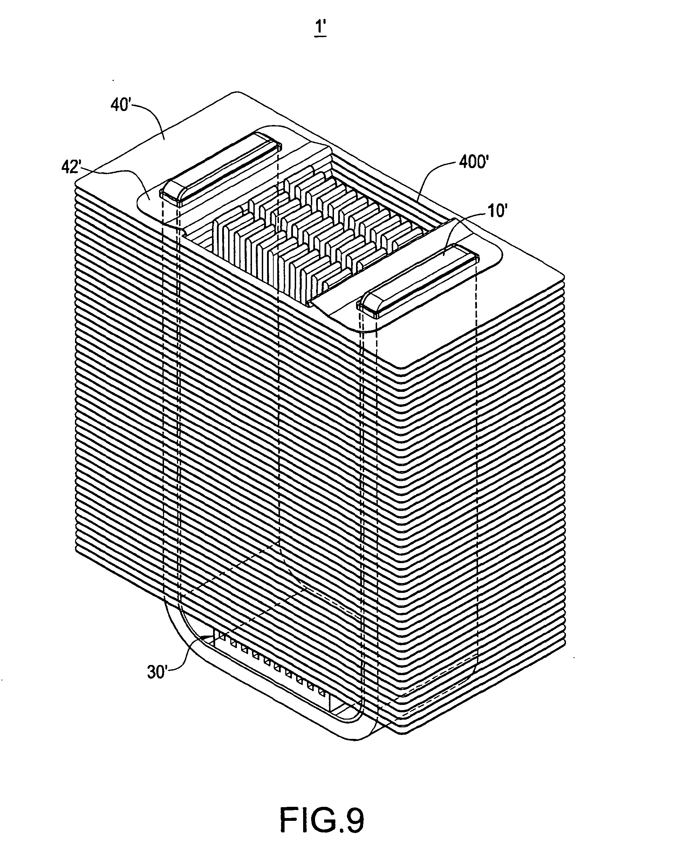

Please refer to FIG. 9, which is a view showing the heat sink of a large area according to the second embodiment of the present invention. The present embodiment is substantially the same as the first embodiment. The difference between the present embodiment and the first embodiment is described as follows. The heat sink 1' is not provided with a heat-conducting base. The fins 40' are penetrated by a flat heat pipe 10'. Each of the fins 40' is provided with two foldable pieces 42' and an accommodating hole 400' is formed between the two foldable pieces 42'. A heat-dissipating body 30' is also accommodated in the accommodating hole 400'.

## Claims

1. A method for manufacturing a heat sink (1) of a large area, comprising the steps of:
a) providing a plurality of fins (40) and a heat pipe (10); **characterised in that** the method further comprises the steps of:
b) cutting each of the fins (40) to form a plurality of cutting lines (41) on each fin (40), the cutting lines forming at least one foldable piece (42);
c) folding back the foldable piece (42) to be overlapped on the fin (40), thereby forming an accommodating hole (400) on the fin (40);
d) punching the fin (40) and the folded piece (42) to form two overlapped through-holes (401, 421);
e) penetrating the two through-holes (441, 421) of the fin (40) and the folded piece (42) by the heat pipe (10); and
f) penetrating other fins (40) by the heat pipe (10) according to the step e).

2. The method for manufacturing a heat sink of a large area according to claim 1, wherein in the step b), the cutting lines (41) form a U shape on each of the fins (40) to form a foldable piece (42) on the fin (40).

3. The method for manufacturing a heat sink of a large area according to claim 1, wherein in the step b), the cutting lines (41) form an H shape on each of the fins (40) to form two foldable pieces (42) on the fin (40).

4. The method for manufacturing a heat sink of a large area according to claim 1, wherein a hollow airflow channel (420) is formed between the folded piece (2) and the fin (40) in the step c).

5. The method for manufacturing a heat sink of a large area according to claim 1, wherein the step d) is performed after the step c), the foldable piece (42) is folded back to be overlapped on the fin (40) in the step c), and the fin (40) and the folded piece (42) overlapped on the fin (40) are punched in the step d).

6. The method for manufacturing a heat sink of a large area according to claim 1, wherein the step d) is performed before the step c), the fin (40) and the foldable piece (42) are punched in the step d) to form two overlapped through-holes (401, 421), the foldable piece (42) is folded back to be overlapped on the fin (40) in the step c), thereby overlapping the two through-holes (401, 421).

7. The method for manufacturing a heat sink of a large area according to claim 1, further comprising, between the step d) and the step e), a step d') of pressing peripheries of the two through-holes (401, 421) to form two overlapped flanges (402, 422) on the peripheries of the two through-holes (401, 421), the flange (402) of the through-hole (401) of the fin (40) being adhered to an outer wall of the heat pipe (10) in the step f).

8. The method for manufacturing a heat sink of a large area according to claim 1, further comprising a step g) of providing a heat-dissipating body (30), the heat-dissipating body (30) being accommodated in the accommodating hole (400) of the fin (40).

9. The method for manufacturing a heat sink of a large area according to claim 1, further comprising a step h) of providing a heat-conducting base (20), the heat pipe (10) being inserted into the heat-conducting base (20).

10. A heat-dissipating fin (40) **characterised in that** the fin is provided with a foldable piece (42), the foldable piece (42) being folded back to be overlapped on the fin (40), **in that** the fin is formed with an accommodating hole (400), the folded piece (42) and the fin (40) being provided with two overlapped through-holes (421, 401), peripheries of the two through-holes (421, 401) being provided with two overlapped flanges (422, 402).

11. The heat-dissipating fin according to claim 10, wherein a hollow airflow channel (420) is formed between the folded piece (42) and the fin (40).

12. A heat sink of a large area, comprising;
a heat pipe (10); and
a plurality of fins (40) parallel to each other and arranged at intervals, the heat pipe (10) penetrating the fins (40), the fin (40) being according to claim 10, the heat pipe (10) penetrating the two through-holes (401, 421) of the fin (40).

13. The heat sink of a large area according to claim 12, wherein the flange (402) of the fin (40) is adhered to an outer wall of the heat pipe (10) tightly.

14. The heat sink of a large area according to claim 12, wherein a hollow airflow channel (420) is formed between the folded piece (42) and the fin (40).

15. The heat sink of a large area according to claim 12, further comprising a heat-dissipating body (30) and a heat-conducting base (20), the heat-dissipating body (30) being disposed in the accommodating holes (400) of the fins (40), the heat-conducting base (20) allowing the heat pipe (10) to be inserted therein.

## Patentansprüche

1. Verfahren zur Herstellung eines Kühlkörpers (1) für einen großen Bereich, das die Schritte umfasst:
a) Bereitstellen mehrerer Rippen (40) und eines Wärmerohres (10); **dadurch gekennzeichnet, dass** das Verfahren ferner die Schritte umfasst:
b) Zuschneiden jeder Rippe (40), um auf jeder Rippe (40) mehrere Schnittlinien (41) auszubilden, wobei die Schnittlinien mindestens ein faltbares Stück (42) bilden;
c) Zurückfalten des faltbaren Stücks (42), um auf der Rippe (40) zu überlappen, um dadurch ein aufzunehmendes Loch (400) auf der Rippe (40) zu bilden;
d) Stanzen der Rippe (40) und des gefalteten Stücks (42), um zwei überlappende Durchgangslöcher (401, 421) auszubilden;
e) Durchdringen der zwei Durchgangslöcher (401, 421) der Rippe (40) und des gefalteten Stücks (42) mit dem Wärmerohr (10); und
f) Durchdringen anderer Rippen (40) mit dem Wärmerohr (10) entsprechend dem Schritt e).

2. Verfahren zur Herstellung eines Kühlkörpers für einen großen Bereich nach Anspruch 1, wobei in dem Schritt b) die Schnittlinien (41) eine U-Form auf jeder der Rippen (40) bilden, um ein faltbares Stück (42) auf der Rippe (40) auszubilden.

3. Verfahren zur Herstellung eines Kühlkörpers für einen großen Bereich nach Anspruch 1, wobei in dem Schritt b) die Schnittlinien (41) eine H-Form auf jeder der Rippen (40) bilden, um zwei faltbare Stücke (42) auf der Rippe (40) auszubilden.

4. Verfahren zur Herstellung eines Kühlkörpers für einen großen Bereich nach Anspruch 1, wobei im Schritt c) zwischen dem gefalteten Stück (42) und der Rippe (40) ein hohler Luftströmungskanal (420) ausgebildet wird.

5. Verfahren zur Herstellung eines Kühlkörpers für einen großen Bereich nach Anspruch 1, wobei der Schritt d) nach dem Schritt c) durchgeführt wird, das faltbare Stück (42) zurückgefaltet wird, um in dem Schritt c) auf der Rippe (40) zu überlappen, und wobei die Rippe (40) und das gefaltete Stück (42), die auf der Rippe (40) überlappen, im Schritt d) gestanzt werden.

6. Verfahren zur Herstellung eines Kühlkörpers für einen großen Bereich nach Anspruch 1, wobei der Schritt d) vor dem Schritt c) durchgeführt wird, die Rippe (40) und das faltbare Stück (42) im Schritt d) gestanzt werden, um zwei überlappende Durchgangslöcher (401, 421) auszubilden, wobei das faltbare Stück (42) zurückgefaltet wird, um in dem Schritt c) auf der Rippe (40) zu überlappen, wodurch die zwei Durchgangslöcher (401, 421) überlappen.

7. Verfahren zur Herstellung eines Kühlkörpers für einen großen Bereich nach Anspruch 1, das ferner zwischen dem Schritt d) und dem Schritt e) einen Schritt d') des Pressens von Begrenzungsflächen der zwei Durchgangslöcher (401, 421) umfasst, um zwei überlappende Flansche (402, 422) auf den Begrenzungsflächen der zwei Durchgangslöcher (401, 421) auszubilden, wobei der Flansch (402) des Durchgangsloches (401) der Rippe (40) in dem Schritt f) an einer äußeren Wand des Wärmerohres (10) durch Haften befestigt wird.

8. Verfahren zur Herstellung eines Kühlkörpers für einen großen Bereich nach Anspruch 1, das ferner einen Schritt g) des Vorsehens eines wärmeabführenden Körpers (30) umfasst, wobei der wärmeabführende Körper (30) in dem aufnehmenden Loch (400) der Rippe (40) untergebracht ist.

9. Verfahren zur Herstellung eines Kühlkörpers für einen großen Bereich nach Anspruch 1, das ferner einen Schritt h) zum Bereitstellen einer wärmeleitenden Basis (20) umfasst, wobei das Wärmerohr (10) in die wärmeleitende Basis (20) eingesetzt wird.

10. Wärmeabführende Rippe (40), **dadurch gekennzeichnet, dass** die Rippe mit einem faltbaren Stück (42) versehen ist, wobei das faltbare Stück (42) zurückgefaltet ist, um auf der Rippe (40) überlappt zu sein, und **dadurch gekennzeichnet, dass** die Rippe mit einem aufnehmenden Loch (400) ausgebildet ist; wobei das faltbare Stück (42) und die Rippe (40) mit zwei Durchgangslöchern (401, 421) versehen sind, wobei die Begrenzungsflächen der zwei Durchgangslöcher (401, 421) mit zwei überlappten Flanschen (402, 422) versehen sind.

11. Wärmeabführende Rippe nach Anspruch 10, wobei zwischen dem gefalteten Stück (42) und der Rippe (40) ein hohler Luftströmungskanal (420) ausgebildet ist.

12. Kühlkörper für einen großen Bereich, der umfasst:
ein Wärmerohr (10); und
mehrere Rippen (40), die parallel zueinander sind und in Intervallen angeordnet sind, wobei das Wärmerohr (10) die Rippen (40) durchdringt, wobei die Rippe (40) wie in Anspruch 10 beschaffen ist und das Wärmerohr (10) die zwei Durchgangslöcher (401, 421) der Rippe (40) durchdringt.

13. Kühlkörper für einen großen Bereich nach Anspruch 12, wobei der Flansch (402) der Rippe (40) an einer äußeren Wand des Wärmerohres (10) durch Haften befestigt ist.

14. Kühlkörper für einen großen Bereich nach Anspruch 12, wobei zwischen dem gefalteten Stück (42) und der Rippe (40) ein hohler Luftströmungskanal (420) ausgebildet ist.

15. Kühlkörper für einen großen Bereich nach Anspruch 12, der ferner einen wärmeabführenden Körper (30) und eine wärmeleitende Basis (20) umfasst, wobei der wärmeabführende Körper (30) in den aufnehmenden Löchern (400) der Rippen (40) angeordnet ist, wobei die wärmeleitende Basis (20) ermöglicht, dass das Wärmerohr (10) in sie eingesetzt werden kann.

## Revendications

1. Procédé de fabrication d'un dissipateur de chaleur (1) à grande surface, comprenant les étapes consistant à :
a) fournir une pluralité d'ailettes (40) et un tube caloporteur (10) ; **caractérisé en ce que** le procédé comprend en outre les étapes consistant à :
b) découper chacune des ailettes (40) pour former une pluralité de lignes de coupe (41) sur chaque ailette (40), les lignes de coupe formant au moins une pièce pliable (42) ;
c) replier la pièce pliable (42) pour être recouverte sur l'ailette (40), formant ainsi un trou de réception (400) sur l'ailette (40) ;
d) poinçonner l'ailette (40) et la pièce pliée (42) pour former deux trous traversants superposés (401, 421) ;
e) faire pénétrer le tube caloporteur (10) dans les deux trous traversants (401, 421) de l'ailette (40) et de la pièce pliée (42) ; et
f) faire pénétrer le tube caloporteur (10) dans d'autres ailettes (40) en accord avec l'étape e).

2. Procédé de fabrication d'un dissipateur de chaleur à grande surface selon la revendication 1, dans lequel, dans l'étape b), les lignes de coupe (41) forment une forme en U sur chacune des ailettes (40) pour former une pièce pliable (42) sur l'ailette (40).

3. Procédé de fabrication d'un dissipateur de chaleur à grande surface selon la revendication 1, dans lequel, dans l'étape b), les lignes de coupe (41) forment une forme en H sur chacune des ailettes (40) pour former deux pièces pliables (42) sur l'ailette (40).

4. Procédé de fabrication d'un dissipateur de chaleur à grande surface selon la revendication 1, dans lequel un canal creux d'écoulement d'air (420) est formé entre la pièce pliée (2) et l'ailette (40) dans l'étape c).

5. Procédé de fabrication d'un dissipateur de chaleur à grande surface selon la revendication 1, dans lequel l'étape d) est exécutée après l'étape c), la pièce pliable (42) est repliée pour être recouverte sur l'ailette (40) dans l'étape c), et l'ailette (40) et la pièce pliée (42) recouvrant l'ailette (40) sont poinçonnées dans l'étape d).

6. Procédé de fabrication d'un dissipateur de chaleur à grande surface selon la revendication 1, dans lequel l'étape d) est exécutée avant l'étape c), l'ailette (40) et la pièce pliable (42) sont poinçonnées dans l'étape d) pour former deux trous traversants superposés (401, 421), la pièce pliable (42) est repliée pour être recouverte sur l'ailette (40) dans l'étape c), en recouvrant ainsi les deux trous traversants (401, 421).

7. Procédé de fabrication d'un dissipateur de chaleur à grande surface selon la revendication 1, comprenant en outre, entre l'étape d) et l'étape e), une étape d') consistant à presser les périphéries des deux trous traversants (401, 421) pour former deux brides superposées (402, 422) sur les périphéries des deux trous traversants (401, 421), la bride (402) du trou traversant (401) de l'ailette (40) étant adhérée sur une paroi extérieure du tube caloporteur (10) dans l'étape f).

8. Procédé de fabrication d'un dissipateur de chaleur à grande surface selon la revendication 1, comprenant en outre une étape g) consistant à prévoir un corps dissipateur de chaleur (30), le corps dissipateur de chaleur (30) étant reçu dans le trou de réception (400) de l'ailette (40).

9. Procédé de fabrication d'un dissipateur de chaleur à grande surface selon la revendication 1, comprenant en outre une étape h) consistant à fournir une base conductrice de la chaleur (20), le tube caloporteur (10) étant inséré dans la base conductrice de la chaleur (20).

10. Ailette de dissipation de chaleur (40), **caractérisé en ce que** l'ailette est pourvue d'une pièce pliable (42), la pièce pliable (42) étant repliée pour être recouverte sur l'ailette (40), **en ce que** l'ailette est formée avec un trou de réception (400), la pièce pliée (42) et l'ailette (40) étant pourvues de deux trous superposés (421, 401), les périphéries des deux trous traversants (421, 401) étant pourvues de deux brides superposées (422, 402).

11. Ailette de dissipation de chaleur selon la revendication 10, dans laquelle un canal creux d'écoulement d'air (420) est formé entre la pièce pliée (42) et l'ailette (40).

12. Dissipateur de chaleur à grande surface, comprenant :
un tube caloporteur (10) ; et
une pluralité d'ailettes (40) parallèles les unes aux autres et agencées à intervalles, le tube caloporteur (10) pénétrant dans les ailettes (40), les ailettes (10) étant réalisées selon la revendication 10, et le tube caloporteur (10) pénétrant dans les deux trous traversants (401, 421) de l'ailette (40).

13. Dissipateur de chaleur à grande surface selon la revendication 12, dans lequel la bride (402) de l'ailette (40) est adhérée sur une paroi extérieure du tube caloporteur (10) de manière intime.

14. Dissipateur de chaleur à grande surface selon la revendication 12, dans lequel un canal creux d'écoulement d'air (420) est formé entre la pièce pliée (42) et l'ailette (40).

15. Dissipateur de chaleur à grande surface selon la revendication 12, comprenant en outre un corps dissipateur de chaleur (30) et une base conductrice de la chaleur (20), le corps dissipateur de chaleur (30) étant disposé dans les trous de réception (400) des ailettes (40), la base conductrice de la chaleur (20) permettant d'insérer le tube caloporteur (10) à l'intérieur.
